**Europäisches Patentamt**

**European Patent Office**

**Office européen des brevets**

(19)

(11) Veröffentlichungsnummer : **0 474 044 B1**

(12) **EUROPÄISCHE PATENTSCHRIFT**

(45) Veröffentlichungstag der Patentschrift :
**26.10.94 Patentblatt 94/43**

(51) Int. Cl.⁵ : **H05K 7/20**

(21) Anmeldenummer : **91114042.4**

(22) Anmeldetag : **22.08.91**

(54) **Kühleinrichtung für Transistor-Leistungsverstärker.**

(30) Priorität : **05.09.90 DE 4028100**

(43) Veröffentlichungstag der Anmeldung :
**11.03.92 Patentblatt 92/11**

(45) Bekanntmachung des Hinweises auf die
Patenterteilung :
**26.10.94 Patentblatt 94/43**

(84) Benannte Vertragsstaaten :
**DE FR GB IT**

�================
(56) Entgegenhaltungen :
**DE-A- 1 766 817**
**DE-A- 2 828 068**

(56) Entgegenhaltungen :
**DE-A- 3 509 908**
**DE-B- 2 015 361**
**US-A- 3 790 859**
**US-A- 4 901 029**

(73) Patentinhaber : **Rohde & Schwarz GmbH & Co.**
**KG**
**Mühldorfstrasse 15**
**D-81671 München (DE)**

(72) Erfinder : **Gebele, Stefan**
**Englschalkinger Strasse 237**
**W-8000 München 81 (DE)**

(74) Vertreter : **Graf, Walter, Dipl.-Ing.**
**Sckellstrasse 1**
**D-81667 München (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft eine Kühleinrichtung für Hochfrequenz- und Mikrowellen-Leistungsbaugruppen laut Oberbegriff des Hauptanspruches.

Kühleinrichtungen dieser Art sind bekannt (DE-AS 20 15 361 bzw. US-PS 4 901 029). Die Verlustleistung abgebenden Bauteile z.B. Transistoren oder Lastausgleichswiderstände sind dabei auf Kühlplatten befestigt, die im Abstand zwischen flachen Hohlplatten angeordnet sind. Durch das Innere der flachen Hohlplatten, die an ihrem unteren Rand in einen Kühlluft-Zufuhrkanal münden, wird Kühlluft zu Düsen geführt, die über die Oberfläche der Hohlplatte verteilt sind, so daß Kühlluft senkrecht auf die Rückseite der die Transistoren tragenden Kühlplatten geblasen wird. Die erwärmte Kühlluft wird dann durch den Spalt zwischen Kühlplatten und Hohlplatten nach oben in einen Abluftkanal abgeführt. Die Richtung der Luftführung ist auch umkehrbar. Die mittels der Düsen mit Kühlluft bestrahlte Rückseite der Kühlplatten ist bei den bekannten Anordnungen flach und eben ausgebildet, der Wärmeaustausch zwischen der Kühlluft und der Kühlplatte ist daher nicht optimal. Außerdem sind die Düsen bei der bekannten Anordnung nicht gleichmäßig über die Oberfläche der Hohlplatte verteilt, sondern vielmehr auf die Bereiche konzentriert, in denen auf der Vorderseite der Kühlplatte die zu kühlenden Transistoren befestigt sind. Auch dadurch ist der Wirkungsgrad dieser bekannten Einrichtungen nicht optimal.

Es ist Aufgabe der Erfindung, eine Kühleinrichtung dieser Art zu schaffen, die einen optimalen Wärmeaustausch zwischen Kühlluft und Kühlplatte gewährleistet, ohne die Abmessungen, das Gewicht bzw. die Herstellkosten zu vergrößern.

Bei anders wirkenden Kühleinrichtungen für Hochfrequenz- und Mikrowellen-Leistungsbaugruppen, bei denen die Kühlluft parallel zu Kühlflächen vorbeistreicht, ist es an sich bekannt, zur Vergrößerung der Oberfläche der Kühlfläche diese mit einer Noppenstruktur zu versehen (DE-A- 17 66 817, US-A- 3 790 859, DE-U- 8 228 451, DE-U- 18 95 660). Durch die Anwendung dieser an sich bekannten Noppenstruktur bei einer Kühleinrichtung der eingangs erwähnten Art (DE-B- 20 15 361), bei welcher die Kühlluft nicht parallel zur den Noppen, sondern vielmehr senkrecht auf die Noppenstruktur auftrifft, wird der überraschende Vorteil erzielt, daß die senkrecht auf die Noppenstruktur auftreffende Luftströmung stark verwirbelt wird. Durch diese starken Turbulenzen im Bereich der Kühlplatten-Rückseite wird der Wärmeaustausch zwischen der Kühlluft und der Kühlplatte stark erhöht, der Wirkungsgrad der Kühlung also wesentlich verbessert. Trotzdem werden die Abmessungen der Kühleinrichtung nicht vergrößert, die Dicke der Kühlplatten und damit deren Gesamtvolumen, das aus konstruktiven Gründen und zur Erzeugung eines ausreichenden Temperaturgefälles je nach Anwendungsart vorgegeben ist, wird nicht vergrößert. Auch der Abstand zwischen den Kühlplatten und der Ebene, in der die Düsen der Hohlplatte liegen, muß bei der erfindungsgemäßen Maßnahme nicht vergrößert werden, der mittlere Abstand der Oberfläche der Kühlplatten gegenüber der flachen Hohlplatte, der nach strömungstechnischen Gesichtspunkten ebenfalls vorgegeben ist, kann genauso groß bleiben wir für eine glatte ebene Kühlplattenrückseite einer bekannten Einrichtung der eingangs erwähnten Art. Auch die Herstellung einer erfindungsgemäßen Kühleinrichtung ist sehr einfach und preiswert, die Noppen können beispielsweise durch Ausfräsen von Längs- und Quernuten aus der Oberfläche einer Aluminiumplatte in der gewünschten Verteilung auf einfache Weise hergestellt werden.

Die Erfindung wird im folgenden anhand einer schematischen Zeichnung an einem Ausführungsbeispiel näher erläutert.

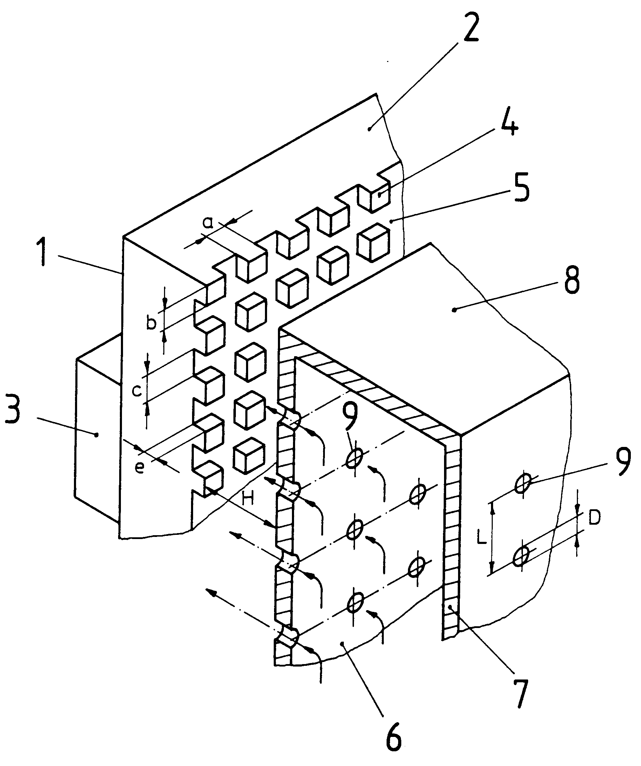

Fig. 1 zeigt perspektivisch den Eckausschnitt einer Kühleinrichtung für einen Transistor-Leistungsverstärker, bei dem auf der Vorderseite 1 einer Kühlplatte 2 aus Aluminium oder Kupfer mehrere Leistungstransistoren 3 befestigt sind, von denen in der Figur nur ein einziger Transistor dargestellt ist. Auf der den Transistoren 3 gegenüberliegenden Rückseite der Kühlplatte 2 ist eine Noppenstruktur ausgebildet, bestehend aus Noppen 4 mit dazwischen ausgebildeten Zwischenräumen 5. Die Noppen 4 sind schachbrettartig über die gesamte Oberfläche der Kühlplatte 2 verteilt, sie besitzen vorzugsweise eine quadratische Oberfläche mit einer Kantenlänge von beispielsweise zwei Millimetern, die Höhe der Noppen beträgt z.B. ebenfalls zwei Millimeter, sie sind vorzugsweise durch Fräsen von Längs- und Quernuten aus einer etwa acht Millimeter starken Aluminiumplatte hergestellt. Im Abstand gegenüber der mit Noppen versehenen Rückseite dieser Kühlplatte 2 ist eine ebenfalls nur bruchstückhaft dargestellte flache Hohlplatte 8 angeordnet, die aus zwei in geringem Abstand voneinander angeordneten Platten 6 und 7 gebildet und seitlich und oben geschlossen ist und die nur im unteren Bereich mit einer Luftzufuhrquelle verbunden ist. In den Platten 6 und 7 sind Düsenöffnungen 9 ausgebildet, die in Richtung auf die gegenüberliegende Rückseite der Kühlplatte 2 gerichtet sind. Ein von unten in den Hohlraum der Hohlplatte 8 zugeführter Luftstrom wird durch die Düsenöffnungen 9 senkrecht in Richtung auf die genoppte Rückseite der Kühlplatte 2 geblasen. Die Düsen 9 sind gleichmäßig über die Oberfläche der Platten 6 und 7 verteilt. Durch das Zusammenwirken dieser gleichmäßig über die Oberfläche verteilten Düsenöffnungen und der ebenfalls gleichmäßig über die Oberfläche der Kühlplatten-Rückseite verteilten Noppen 4 wird ein optimaler Wärmeaustausch zwischen Kühlluft und Kühlplatte 2 erreicht und damit die in beliebiger Verteilung auf der Vorderseite 1 der Kühlplatte verteilten Leistungstransistoren 3 optimal gekühlt. Die erwärmte Kühlluft wird im Spalt zwischen Kühlplatte 2 und Hohlplatte 8 nach oben oder unten abgezogen. Auf der der Kühlplatte 2 gegenüberliegenden Seite der Hohlplatte 8, die in der Platte 7 ebenfalls Düsenöffnungen 9 aufweist, ist vorzugsweise in gleicher Anordnung eine weitere genoppte Kühlplatte 2 mit auf der Vorderseite angebrachten Transistoren angeordnet.

Ein optimaler Wärmeaustausch wird erreicht wenn folgende Dimensionierungsvorschriften für die in der Fig. eingezeichneten Abmessungen eingehalten werden, wobei a die Breite der Noppen 4, b die Längsabmessung dieser Noppen 4, c der Abstand zwischen den Noppen 4 (Breite der Zwischennuten 5), e die Tiefe der zwischen den Noppen 4 ausgebildeten Nuten 5 ist und D der Durchmesser der Düsen 9, L der Mittenabstand dieser Düsen 9 und H der Abstand zwischen der Oberseite der die Düsen 9 aufweisenden Platten 6 bzw. 7 und der Oberfläche der Noppen 4 ist:

1) $a = b$

2) $a = c$

3) $0{,}5 \leq \dfrac{a}{e} \leq 2$

4) $0{,}5 \leq \dfrac{D}{a} \leq 1{,}5$

5) $1 \leq \dfrac{L}{H} \leq 3$

6) $2 \leq \dfrac{H}{e} \leq 5$

Wenn all diese sechs Dimensionierungsvorschriften, die experimentell ermittelt wurden, gleichzeitig angewendet werden, ist der Wirkungsgrad optimal.

## Patentansprüche

1. Kühleinrichtung für Hochfrequenz- oder Mikrowellen-Leistungsbaugruppen, deren Verlustleistungsquellen (3) auf der Vorderseite einer Kühlplatte (2) befestigt sind, auf deren Rückseite aus einer im Abstand gegenüberliegenden flachen Hohlplatte (8) mit mehreren über deren Oberfläche verteilten Düsen (9) Kühlluft senkrecht auf die Rückseite der Kühlplatte (2) geblasen und durch den Spalt zwischen Kühlplatte (2) und Hohlplatte (8) abgeführt wird, dadurch **gekennzeichnet,** daß die Oberfläche der Rückseite der Kühlplatte (2) eine Noppenstruktur (4,5) aufweist.

2. Kühleinrichtung nach Anspruch 1, dadurch **gekennzeichnet,** daß sowohl die Düsen (9) gleichmäßig über die Oberfläche der Hohlplatte (8) als auch die Noppen (4) gleichmäßig über die Oberfläche der Kühlplatte (2) verteilt sind.

3. Kühleinrichtung nach Anspruch 1 oder 2, dadurch **gekennzeichnet,** daß die Noppen (4) quadratisch ausgebildet sind (a = b) und schachbrettartig gleichmäßig über die Rückseite der Kühlplatte (2) verteilt sind.

4. Kühleinrichtung nach Anspruch 3, dadurch **gekennzeichnet,** daß der Abstand (c) zwischen den Noppen (4) etwa gleich groß wie die Breite (a) der quadratischen Noppen (4) gewählt ist (a = c).

5. Kühleinrichtung nach Anspruch 3 oder 4, dadurch **gekennzeichnet,** daß die Tiefe (e) der zwischen den Noppen (4) ausgebildeten Nuten (5) etwa 0,5- bis zweimal so groß wie die Breite (a) der quadratischen Noppen (4) gewählt ist ($0{,}5 \leq \dfrac{a}{e} \leq 2$).

6. Kühleinrichtung nach einem der Ansprüche 3 bis 5, dadurch **gekennzeichnet,** daß der Durchmesser (d) der Düsen (9) etwa 0,5- bis 1,5-mal so groß wie die Breite (a) der quadratischen Noppen (4) gewählt ist ($0{,}5 \leq \dfrac{D}{A} \leq 1{,}5$).

7. Kühleinrichtung nach einem der vorhergehenden Ansprüche 3 bis 6, dadurch **gekennzeichnet,** daß der Mittenabstand zwischen den Düsen (9) etwa einbis dreimal so groß wie der Abstand (h) zwischen der Düsen-Hohlplatte (8) und der Oberfläche der Noppen (4) gewählt ist ($1 \leq \dfrac{L}{H} \leq 3$).

8. Kühleinrichtung nach einem der vorhergehenden Ansprüche 3 bis 7, dadurch **gekennzeichnet,** daß der Abstand (h) zwischen der Düsen-Hohlplatte (8) und der Oberfläche der Noppen (4) etwa zwei bis fünfmal so groß wie die Tiefe (e) der Noppen (4) gewählt ist ($2 \leq \dfrac{H}{e} \leq 5$).

9. Kühleinrichtung nach Anspruch 1 oder 2, dadurch **gekennzeichnet,** daß die Maßnahmen nach den Ansprüchen 3 bis 8 in Kombination angewendet sind.

10. Kühleinrichtung nach einem der vorhergehenden Ansprüche, dadurch **gekennzeichnet,** daß die Noppen (4) eine flache ebene Oberfläche und die dazwischen angeordneten Nuten (5) einen flachen ebenen Boden besitzen.

11. Kühleinrichtung nach einem der vorhergehenden Ansprüche, dadurch **gekennzeichnet,** daß die Noppen (4) durch Fräsen von Längs- und Quernuten aus der Oberfläche einer ebenen Metallplatte hergestellt sind.

12. Kühleinrichtung nach einem der vorhergehenden Ansprüche, dadurch **gekennzeichnet,** daß die Oberflächen der Noppen (4) und/oder der dazwischen ausgebildeten Nuten (5) aufgerauht sind.

13. Kühleinrichtung nach einem der vorhergehenden Ansprüche, dadurch **gekennzeichnet,** daß die Kühlplatte (2) aus Aluminium besteht.

**Claims**

1. Cooling device for radio-frequency or microwave power assemblies whose power-dissipating sources (3) are fastened on the front face of a cooling plate (2), on the reverse face of which cooling air is blasted vertically onto the reverse of the cooling plate (2) out of a flat hollow plate (8) spaced above it and incorporating a plurality of jets (9) distributed over its surface, and is discharged through the gap between the cooling plate (2) and hollow plate (8), characterised in that the surface of the reverse of the cooling plate (2) exhibits a burled or knobby structure (4, 5).

2. Cooling device according to claim 1, characterised in that both the jets (9) are uniformly distributed over the surface of the hollow plate (8) and the burls or knobs (4) are uniformly distributed over the surface of the cooling plate (2).

3. Cooling device according to claim 1 or 2, characterised in that the burls or knobs (4) are square-shaped (a = b) and are distributed in the manner of a chessboard uniformly over the reverse of the cooling plate (2).

4. Cooling device according to claim 3, characterised in that the distance (c) between the burls or knobs (4) is roughly identical to the width (a) of the square burls or knobs (4) (a = c).

5. Cooling device according to claim 3 or 4, characterised in that the depth (e) of the slots (5) formed between the burls or knobs (4) is roughly 0.5 to twice the size of the width (a) of the square burls or knobs (4) ($0.5 \leq \frac{a}{e} \leq 2$).

6. Cooling device according to any of claims 3 to 5, characterised in that the diameter (d) of the jets (9) is roughly 0.5 to 1.5 times the size of the width (a) of the square burls or knobs (4) ($0.5 \leq \frac{D}{a} \leq 1.5$).

7. Cooling device according to any of preceding claims 3 to 6, characterised in that the distance between the centres of the jets (9) is roughly one to three times the size of the distance (h) between the jet-incorporating hollow plate (8) and the surface of the burls or knobs (4) ($1 \leq \frac{L}{H} \leq 3$).

8. Cooling device according to any of preceding claims 3 to 7, characterised in that the distance (h) between the jet-incorporating hollow plate (8) and the surface of the burls or knobs (4) is roughly twice to five times the depth (e) of the burls or knobs (4) ($2 \leq \frac{H}{e} \leq 5$).

9. Cooling device according to claim 1 or 2, characterised in that the measures under claims 3 to 8 are applied in combination.

10. Cooling device according to any of the preceding claims, characterised in that the burls or knobs (4) have a flat, level surface and the intervening slots (5) have a flat, level floor.

11. Cooling device according to any of the preceding claims, characterised in that the burls or knobs (4) are produced by milling longitudinal and transverse slots out of the surface of a plane metal plate.

12. Cooling device according to any of the preceding claims, characterised in that the surfaces of the burls or knobs (4) and/or of the intervening slots (5) are roughened.

13. Cooling device according to any of the preceding claims, characterised in that the cooling plate (2) consists of aluminium.

**Revendications**

1. Dispositif de refroidissement pour des ensembles à haute fréquence ou à micro-ondes, dont les sources de pertes d'énergie (3) sont fixées sur la face antérieure d'une plaque de refroidissement (2), sur le verso de laquelle on souffle à partir d'une plaque creuse (8) plate située en regard à une certaine distance de l'air frais avec plusieurs buses (9) réparties sur sa surface sur le verso de la plaque de refroidissement (2) et on évacue l'air à travers la fente comprise entre la plaque de refroidissement (2) et la plaque creuse (8), dispositif caractérisé en ce que la surface du verso de la plaque de refroidissement (2) présente une structure à nopes (4, 5).

2. Dispositif de refroidissement selon la revendication 1, caractérisé en ce qu'aussi bien les buses (9) sont réparties régulièrement sur la surface de la plaque creuse (8) comme aussi les nopes (4) sont réparties régulièrement sur la surface de la plaque de refroidissement (2).

3. Dispositif de refroidissement selon la revendication 1 ou 2, caractérisé en ce que les nopes (4) sont constituées sous une forme quadratique (a = b) et sont réparties régulièrement à la manière d'un échiquier sur le verso de la plaque de refroidissement (2).

4. Dispositif de refroidissement selon la revendication 3, caractérisé en ce qu'on choisit la distance (c) entre les nopes (4) de façon à peu'près aussi grande que la largeur (a) des nopes quadratiques (4) (a = c).

5. 5°) Dispositif de refroidissement selon la revendication 3 ou 4, caractérisé en ce qu'on choisit la profondeur (e) des rainures (5) constituées entre les nopes (4) à peu près 0,50 deux fois aussi grande que la largeur (a) des nopes quadratiques (4) (0,5 $\leq \dfrac{a}{e} \leq$ 2.

6. Dispositif de refroidissement selon l'une des revendications 3 à 5, caractérisé en ce que l'on choisit le diamètre (d) des buses (9) à peu près 0,5 à 1,5 fois aussi grand que la largeur (a) des nopes quadratiques (4) (0,5 $\leq \dfrac{D}{a} \leq$ 1,5).

7. Dispositif de refroidissement selon l'une des revendications précédentes 3 à 6, caractérisé en ce que l'on choisit la distance moyenne entre les buses (9) environ une à trois aussi grande que la distance (h) comprise entre la plaque creuse à buses (8) et la surface des nopes (4) (1 $\leq \dfrac{L}{H} \leq$ 3).

8. Dispositif de refroidissement selon l'une des revendications précédentes 3 à 7, caractérisé en ce que l'on choisit la distance (h) entre la plaque creuse à buses (8) et la surface des nopes (4) à peu près deux à cinq fois aussi grande que la profondeur (e) des nopes (4) (2 $\leq \dfrac{H}{z} \leq$ 5).

9. Dispositif de refroidissement selon la revendication 1 ou 2, caractérisé en ce que l'on utilise les mesures selon les revendications 3 à 8 en combinaison.

10. Dispositif de refroidissement selon l'une des revendications précédentes, caractérisé en ce que les nopes (4) possédent une surface plate, plane et les rainures qui sont disposées entre (5) un fond également plat.

11. Dispositif de refroidissement selon l'une des revendications précédentes, caractérisé en ce que les nopes (4) sont fabriquées en faisant des rainures transversales et des rainures longitudinales à partir de la surface d'une plaque métallique plane.

12. Dispositif de refroidissement selon l'une des revendications précédentes, caractérisé en ce que les surfaces des nopes (4) et/ou des rainures constituées entre (5) sont rendues rugueuses.

13. Dispositif de refroidissement selon l'une des revendications précédentes, caractérisé en ce que la plaque de refroidissement (2) est en aluminium.